Europäisches Patentamt

European Patent Office

Office européen des brevets

(19)

(11) Numéro de publication : **0 511 137 A1**

(12) **DEMANDE DE BREVET EUROPEEN**

(21) Numéro de dépôt : **92450003.6**

(22) Date de dépôt : **17.04.92**

(51) Int. Cl.⁵ : **G01R 31/02, G01R 27/18**

(30) Priorité : **22.04.91 FR 9105341**

(43) Date de publication de la demande :
**28.10.92 Bulletin 92/44**

(84) Etats contractants désignés :
**BE DE DK ES GB IT NL SE**

(71) Demandeur : **AEROSPATIALE Société
Nationale Industrielle
37, Boulevard de Montmorency
F-75781 Paris Cédex 16 (FR)**

(72) Inventeur : **Lherm, André-Georges
15 rue des Lys
F-33185 Le Haillan (FR)**

(74) Mandataire : **Thébault, Jean-Louis
Cabinet Thébault S.A. 1 Allées de Chartres
F-33000 Bordeaux (FR)**

(54) **Procédé et dispositif de mesure et de contrôle de l'isolement électrique d'un système actif.**

(57) — L'invention vise un procédé qui consiste à effectuer, au cours d'une séquence de quatre échelons de temps successifs, d'une même durée égale à la période, ou un multiple de la période, du courant alternatif de fuite susceptible d'affecter le système : une mesure de la tension de mode commun ($V_{MC}$) entre un point de référence électrique du système (A) et la masse environnante (M), une injection d'un courant continu (I) d'amplitude déterminée, parallèlement à une mesure de la somme de la tension de mode commun et de la tension aux bornes de l'impédance de fuite ($Z_f$) générée par ledit courant injecté, une mesure de la différence entre la somme des tensions mesurées à l'étape 2/ et la tension de mode commun mesurée à l'étape 1/, et une remise à zéro des circuits de mesure des étapes 1 et 2, en sorte d'obtenir par l'étape 3/, le courant injecté (I) étant connu, la valeur de l'impédance de fuite du système.

— Application à la mesure et au contrôle de l'isolement électrique d'un système actif.

FIG.1.

La présente invention a trait à la mesure et au contrôle de l'isolement électrique d'un système actif en vue notamment de détecter d'éventuels défauts d'isolement.

Par système actif on entend un système constitué d'une source d'énergie électrique, continue ou alternative, reliée par des conducteurs à des équipements, en particulier de mesure.

L'invention s'applique notamment à des systèmes électriques de mesure embarqués par exemple sur des fusées, des engins, des satellites, et vise à proposer un procédé de mesure et contrôle de l'isolement électrique de tels systèmes en vue en particulier de déceler des défauts d'isolement, tout spécialement de défauts fugitifs, pendant le fonctionnement du système et, ce, sans perturber ce fonctionnement .

De tels systèmes de mesure embarqués sont soumis à des cycles d'essais et de mesure qui peuvent être perturbés intempestivement et aléatoirement par des défauts d'isolement entre la référence de mesure électrique du système actif et la masse mécanique environnante de l'engin ou de la structure emportant le système actif, que cet engin, ou cette structure, soit relié à la terre (essais au sol par exemple) ou non.

Il importe donc de mesurer et contrôler l'impédance d'isolement du système actif.

On sait que l'isolement électrique d'un tel système est lié à l'existence d'une impédance de fuite entraînant l'apparition d'une tension électrique dite de mode commun, continue ou alternative, entre un point du circuit d'alimentation des équipements du système actif et la masse mécanique environnante dont il doit être normalement isolé, laquelle tension de mode commun génère un courant de fuite.

Ces tensions de mode commun apparaissent par suite de défauts d'isolement.

L'invention vise à mesurer l'isolement ou les courts-circuits entre le point chaud correspondant à la référence électrique du système actif et la masse environnante et à contrôler, notamment en régime dynamique, si l'isolement satisfait des conditions préfixées et, dans le cas négatif, à générer un signal de sanction.

Actuellement, on utilise deux techniques pour mesurer l'isolement, à savoir une mesure en statique par essai de claquage diélectrique sous tension, ou une mesure en dynamique par mise sous tension impulsionnelle du système à contrôler, avec vérification du niveau de réponse.

Ces deux techniques présentent des inconvénients.

Dans le premier cas, on ne vérifie pas la mesure en fonctionnement, c'est-à-dire que l'on ne s'affranchit pas, dans le cas de commutation électrique, des variations dues aux conditions de câblage des circuits actifs (commutation des masses du système en cours de fonctionnement, point froid par rapport aux masses mécaniques, mesure, terre).

Dans le deuxième cas, les mesures sous tension ont un inconvénient majeur, celui de ne pouvoir s'affranchir des tensions dites de mode commun qui peuvent totalement fausser la mesure. En effet, les composantes continues ou alternatives viennent se superposer à l'échelon de mesure.

Dans les dispositifs connus de mesure d'isolement, en particulier de réseau électrique, on peut citer le dispositif décrit dans le document FR 1.586.914 et dans lequel on injecte dans le réseau un courant à une fréquence différente de celle du réseau et on mesure ainsi, par l'intermédiaire du courant de fuite généré par le courant injecté, l'isolement du réseau.

Outre que cette technique ne permet pas de s'affranchir des tensions de mode commun, elle n'est pas conçue pour effectuer une surveillance permanente du paramètre isolement indépendamment du cycle de fonctionnement du système à contrôler, en vue, par exemple, de déceler des défauts fugitifs.

Par le document FR-2.514.903 on connaît un dispositif de mesure d'une impédance, plus précisément la capacité d'un composant à semi-conducteur. Dans ce dispositif, on effectue un suivi dynamique de la mesure d'indépendance d'isolement par une méthode d'injection d'impulsions périodiques, mais qui ne permet pas non plus de s'affranchir des tensions de mode commun générées par des défauts d'isolement.

Enfin, par le document FR-2.616.228, on connaît un dispositif de contrôle et de mesure de l'isolement d'un réseau électrique par l'injection d'un signal alternatif de référence dans le réseau et la mesure de l'état d'isolement de ce dernier en réponse à l'émission dudit signal de référence.

Si ce dispositif comporte des moyens de discrimination des composantes du signal de mesure, à savoir, une première composante du courant de fuite et une seconde composante fonction du courant circulant dans la capacité parasite du réseau, il ne permet pas non plus de s'affranchir des tensions de mode commun générées par les défauts d'isolements et qui affectent les deux composantes susdites.

Le but de l'invention est de proposer un procédé de mesure et de contrôle de l'isolement d'un système actif en fonctionnement, sans perturber ce fonctionnement, en s'affranchissant des tensions de mode commun et notamment en vue d'effectuer le suivi de la mesure d'isolement en dynamique afin de déceler des défauts fugitifs pouvant apparaître , par exemple, lors du déroulement des séquences automatiques du système.

A cet effet, l'invention a pour objet un procédé de mesure et de contrôle de l'isolement électrique d'un système actif, caractérisé en ce qu'il consiste à effectuer, au cours d'une séquence de quatre échelons de temps successifs, d'une même durée égale à la période, ou un multiple de la période, du courant alternatif de fuite susceptible d'affecter le système :

1/ une mesure de la tension de mode commun entre un point de référence électrique du système et la masse environnante,

2/ une injection d'un courant continu d'amplitude déterminée, parallèlement à une mesure de la somme de la tension de mode commun et de la tension aux bornes de l'impédance de fuite générée par ledit courant injecté,

3/ une mesure de la différence entre la somme des tensions mesurées à l'étape 2/ et la tension de mode commun mesurée à l'étape 1/, et

4/ une remise à zéro des circuits de mesure des étapes 1 et 2,

en sorte d'obtenir par l'étape 3/, le courant injecté étant connu, la valeur de l'impédance de fuite du système.

Suivant une caractéristique du procédé de l'invention, les mesures effectuées aux étapes 1/, 2/ et 3/ sont opérées sur une durée égale à la période ou un multiple de la période du courant alternatif de fuite susceptible d'affecter le système actif, c'est-à-dire, en fait, le secteur alternatif 50 Hz ou 60 Hz, ce qui a pour conséquence de rendre nulles les valeurs moyennes des tensions de mode commun générées par les courants de fuite ou des tensions résultant de fuite, induites par le secteur 50 Hz ou 60 Hz.

Le procédé permet de réduire l'échelon de temps de mesure à une durée de 20 ms correspondant à une période du secteur alternatif 50 Hz, ce qui donne un cycle complet de mesure de ladite impédance de fuite s'étendant sur 80 ms, alors que l'utilisation, par exemple, d'un filtre actif efficace nécessiterait un temps de réponse supérieur à la seconde.

Le procédé de l'invention permet ainsi par la mesure de l'isolement et sa comparaison avec un seuil préétabli, par exemple une perturbation de l'isolement d'une valeur égale à 100 K $\Omega$, la détection rapide de défauts fugitifs, sous réserve qu'ils soient d'une durée au moins égale à 100 ms, en particulier ceux pouvant apparaître lors du déroulement des séquences automatiques du système à contrôler.

Le cycle de mesure ci-dessus peut bien entendu se répéter aussitôt en sorte d'assurer une surveillance permanente du paramètre isolement, indépendamment du cycle de fonctionnement du système actif à contrôler.

Le procédé de l'invention permet, par le choix d'une durée de l'échelon de mesure beaucoup plus grande qu'une période du secteur alternatif, tout en restant un multiple de cette période, par exemple 10 secondes, de mesurer des isolements supérieurs à 20 M $\Omega$.

Le procédé permet également, en option, de mesurer la tension continue de mode commun indépendamment de la recherche de défaut d'isolement et éventuellement de délivrer un signal de sanction si le niveau de cette tension continue de mode commun est supérieure ou inférieure à un seuil prédéterminé.

L'invention a également pour objet un dispositif pour la mise en oeuvre du procédé ci-dessus.

D'autres caractéristiques et avantages ressortiront de la description qui va suivre d'un dispositif pour la mise en oeuvre du procédé de l'invention, description donnée à titre d'exemple uniquement et en regard des dessins annexés sur lesquels :

- Figure 1 est un schéma illustrant le principe de mesure selon l'invention ;
- Figure 2 est un chronogramme d'un cycle de mesure selon le procédé de l'invention ;
- Figures 3a à 3d sont des diagrammes des tensions électriques en différents points du circuit schématisé en figure 1 ;
- Figure 4 est le schéma électrique d'un dispositif de mesure d'isolement mettant en oeuvre le procédé de l'invention, et
- Figure 5 est un schéma illustrant un mode d'obtention des signaux définissant les quatre étapes du cycle de mesure du procédé.

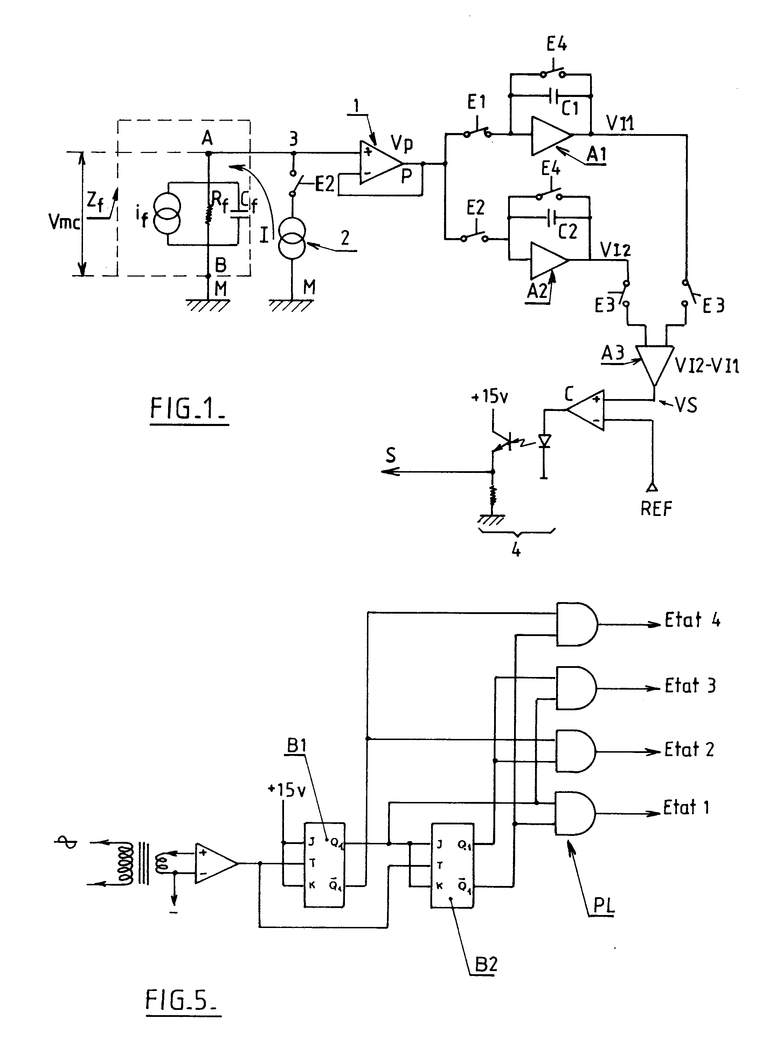

Sur la figure 1, on a symbolisé en $Z_f$ l'impédance de fuite entre un point A dénommé point "chaud" correspondant à la référence électrique d'un système actif, cette référence étant également dénommée référence de mesure électrique "flottante" et un point B représentant la masse mécanique M de l'installation, par exemple une fusée, un satellite, un engin spatial ou aéronautique, sur laquelle est monté le système actif à contrôler.

L'isolement électrique du système se caractérise par ladite impédance $Z_f$, comprenant une composante ohmique $R_f$ et une composante capacitive $C_f$ et qui est le siège, lorsqu'apparaît un défaut d'isolement, d'un courant de fuite, c'est-à-dire qu'une partie du courant de la source d'alimentation du système actif passe par la masse M et shunte tout ou partie des équipements alimentés, ou d'un courant, continu ou alternatif, résultant de courants vagabonds d'origine externe au système, en particulier de tensions induites par le réseau général de distribution d'électricité, c'est à dire en fait le secteur 50 Hz ou 60 Hz selon le pays considéré.

Le dispositif représenté sur la figure 1, comporte un amplificateur opérationnel 1 monté en suiveur et dont une entrée est reliée au point A. Cet amplificateur comporte une très grande impédance d'entrée permettant d'effectuer des mesures sans perturber l'impédance d'isolement.

Une source de courant continu 2 peut être branchée par l'intermédiaire d'un contact E2, en un point 3 de la liaison point A-amplificateur 1, aux bornes de l'impédance $Z_f$.

La sortie de l'amplificateur 1 est reliée en parallèle à deux étages d'intégration constitué chacun d'un amplificateur, respectivement $A_1$ et $A_2$ et d'un condensateur en parallèle, respectivement C1 et C2.

Chaque étage intégrateur est relié à l'amplificateur 1 par l'intermédiaire d'un contact E1 et E2 respectivement, cependant que chaque condensateur C1, C2 est muni d'un contact de court-circuitage E4.

Les sorties des étages intégrateurs sont reliées aux entrées d'un amplificateur soustracteur A3, via un contact E3. La sortie de l'amplificateur A3 est reliée à une première entrée d'un amplificateur comparateur C dont une seconde entrée reçoit un signal de référence de tension REF préfixée.

Le comparateur C délivre en sortie un signal transmis, via un découpleur anti-perturbations 4, sous forme d'un signal tout ou rien S à destination par exemple d'une installation de contrôle et/ou de traitement.

Le principe du procédé de mesure selon l'invention consiste à effectuer une mesure de la tension entre le point A et la masse M, d'une part, avant l'injection d'un courant continu I de valeur connue puis, d'autre part, pendant l'injection dudit courant I, les deux mesures étant effectuées pendant des laps de temps égaux à la période ou à un multiple de la période du secteur alternatif susceptible de perturber le système actif, en sorte d'obtenir par différence entre les deux mesures la valeur $Z_f I$, c'est-à-dire, I étant connu, la valeur de l'impédance de fuite $Z_f$.

A cet effet, pendant un premier laps de temps dénommé étape ou état 1, le contact E1 est fermé, les autres contacts E2 à E4 demeurant ouverts, en sorte que le dispositif de la figure 1 permet la mesure, par l'intégrateur A1-C1, de la tension de mode commun $V_{MC}$ entre les points A et B.

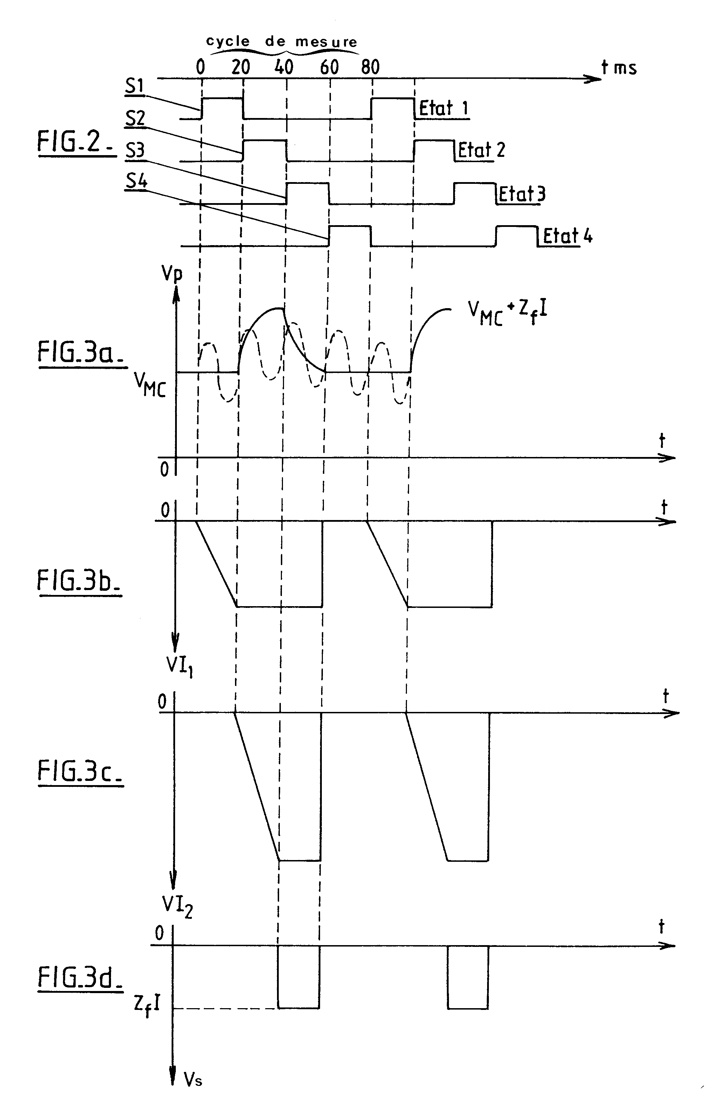

Ce premier laps de temps est représenté par le signal carré S1 du chronogramme de la figure 2.

La durée de fermeture du contact E1 est fixée à 20 ms, correspondant à une période du secteur 50 Hz.

Pendant un deuxième laps de temps de même valeur, dénommé étape ou état 2, illustré par le signal carré S2, les contacts E2 sont fermés, les autres contacts E1, E3, E4 étant, durant le même laps de temps, maintenus ou ramené à l'état ouvert. Au cours de cette étape est mesurée, par l'intégrateur A2-C2, la somme $V_{MC} + Z_f I$ résultant de l'injection par la source 2 du courant continu I de valeur connue pré-fixée.

Puis, pendant un troisième laps de temps, également de même valeur, dénommé étape ou état 3, illustré par le signal carré S3, les contacts E3 sont fermés, les autres contacts E1, E2, E4 étant, durant le même laps de temps, maintenus ou ramenés à l'état ouvert.

Au cours de cette étape 3, les grandeurs $V_{MC}$ et $V_{MC} + Z_F I$ respectivement stockées dans les condensateurs C1 et C2, sont, en même temps, envoyées sur l'amplificateur soustracteur A3.

Enfin, au cours d'un quatrième laps de temps, également fixé à 20 ms, dénommé étape ou état 4, illustré par le signal carré S4, les contacts E4 sont fermés, les autres contacts E1, E2, E3 étant maintenus ou ramenés à l'état ouvert.

Au cours de cette quatrième étape les condensateurs C1,C2 sont déchargés.

Les quatre étapes ou états 1 à 4 sont de préférence effectuées de manière enchaînée, en sorte de ramener un cycle complet de mesure, comme illustré par la figure 2, sur une durée totale de 80 ms.

A partir du signal de tension fourni par l'amplificateur soustracteur A3, qui est la mesure de $Z_f I$, le comparateur C effectue la comparaison entre cette mesure et une référence de tension REF correspondant à un seuil d'isolement souhaité, en sorte que le comparateur C est susceptible de fournir en S un signal, dit de sanction, à chaque fois que l'amplificateur soustracteur A3 détecte une tension de fuite $Z_f I$ inférieure à un seuil de tension prédéterminé fixé par calibration comme il sera explicité plus loin et qui correspond à une perturbation de l'isolement d'une valeur considérée comme critique, par exemple 100 K $\Omega$.

La figure 3 représente la courbe de variation de la tension Vp de sortie de l'amplificateur suiveur 1 au cours des cycles de mesure de la figure 2.

Dans l'état 1, la tension Vp est égale à la tension de mode commun $V_{MC}$. A l'état 2, elle passe à la valeur $V_{MC} + Z_f I$ pour revenir à la valeur $V_{MC}$ au cours de l'état 3, du fait de l'ouverture simultanée des contacts E1, E2.

On a représenté en pointillés sur la figure 3a, les éventuelles variations sinusoïdales, de fréquence 50 Hz, de la tension de mode commun $V_{MC}$. Ces variations présentent une valeur moyenne nulle pour chacun des états 1,2,3 et 4 qui ont une durée égale à une période de ladite tension sinusoïdale. Il est à noter que le cycle de mesure est synchronisé sur la fréquence du secteur 50 Hz afin d'obtenir ladite valeur moyenne nulle pour chaque étape de traitement.

Les figures 3b et 3c représentent la courbe de variation respectivement de la tension $V_{I1}$ à la sortie de l'intégrateur A1-C1 et de la tension $V_{I2}$ à la sortie de l'intégrateur A2-C2 au cours dudit cycle de mesure de la figure 2.

La figure 3d représente le signal carré de la tension de sortie Vs de l'amplificateur soustracteur A3, c'est à dire la tension $Z_f I$.

Plus précisément, à l'étape 1 on mesure la tension :

$$V_{I_1} = - \frac{1}{CR} \int_O^{20.10^{-3}} \pm V_{MC} dt$$

Avec CR, constante d'intégration du circuit de mesure (A1-C1), égal à $20.10^{-3}$ seconde, on a $V_{I1} = \pm V_{MC}$.

Durant les étapes 2 et 3, l'intégrateur A1-C1 étant déconnecté du circuit, maintient son niveau de sortie à la valeur $V_{I1}$.

A l'étape 2, suite à l'injection du courant + I, la tension aux bornes de $Z_f$ suit la loi :

$$Ve = V_\infty - (V_\infty - Vinitiale) e^{-t/\tau}$$

La tension en sortie du suiveur 1 s'exprime sous la forme :

$$Vp = (Z_f I \pm V_{MC}) - [ (Z_f I \pm V_{MC}) - (\pm V_{MC}) ] e^{-t/\tau}$$

avec

t = durée d'un état (20 ms)

$\tau = R_f \times C_f$ = constante de temps du circuit de fuite.

CR = constante d'intégration du circuit de mesure (A2-C2).

soit $Vp = \pm V_{MC} + Z_f I (1 - e^{-t/\tau})$

Ce qui donne en sortie de l'intégrateur (A2-C2)

$$V_{I_2} = - \frac{1}{CR} \int_O^{20.10^{-3}} \pm V_{MC} dt - \frac{1}{CR} \int_O^{20.10^{-3}} Z_f I (1 - e^{-t/\tau}) \, dt$$

$V_{I2}$ est maintenue durant l'état 3.

A l'étape 3, on effectue à l'aide du soustracteur A3 la différence $V_{I2} - V_{I1}$, ce qui donne le niveau $Z_f I$ ; en effet :

$$Vs = - \frac{1}{CR} \int_O^{20.10^{-3}} \pm V_{MC} \, dt - \frac{1}{CR} \int_O^{20.10^{-3}} Z_f I \, (1 - e^{-t/\tau}) \, dt - (- \frac{1}{CR} \int_O^{20.10^{-3}} \pm V_{MC} dt)$$

d'où

$$Vs = - \frac{1}{CR} \int_O^{20.10^{-3}} Z_f I \, (1 - e^{-t/\tau}) \, dt$$

Si $t \gg \tau$, on aura

$$Vs = - \frac{1}{CR} \int_O^{20.10^{-3}} Z_f I \, dt$$

avec CR = $20.10^{-3}$ seconde, on a $Vs = - Z_f I$

La tension Vs est comparée à la référence de tension REF. En supposant que cette dernière est fixée par exemple à la valeur - 20 V et que le courant I injecté est fixé à + $1_\mu$ A :

Si Vs = - $Z_f$I ≦ - 20 V, ce qui correspond à une impédance $Z_f$≦ 20 M Ω, le comparateur C délivrera un signal S.

La tension de mode commun peut être négative ou positive mais le processus de mesure exposé ci-dessus conduit à l'obtention d'un même signe sur la valeur $Z_f$ I.

Dans l'expression de Vs on néglige le terme $e^{-t/\tau}$ si t>>τ. Dans ce cas, Vs = - $Z_f$I. On considère ce résultat obtenu pour t = 5 τ.

Or, si on trace les courbes Vs = f($Z_f$) pour différentes valeurs de la capacité de fuite $C_f$, pour une valeur du courant injecté I, on constate que la durée d'un cycle de mesure selon l'invention est liée à la capacité des diélectriques.

Plus cette dernière est grande et plus le temps de mesure sera élevé pour obtenir une même valeur d'impédance $Z_f$I.

Aussi, le procédé de l'invention pourra être utilisé pour la détection de défaut fugitif entraînant une chute de l'impédance d'isolement en deça d'un seuil que l'on pourra fixé à une valeur choisie, par exemple 100 K Ω et en réglant les constantes de temps des intégrateurs A1-C1 et A2-C2 à des valeurs de 20 ms, le procédé permettra de détecter des défauts fugitifs de 100 K Ω d'une durée égale ou supérieure à 100 ms, la durée d'un cycle de mesure étant, comme il a été décrit plus haut, susceptible d'être fixée à un minimum de 80 ms.

La surveillance permanente de tels défauts sera effectuée en répétant automatiquement des cycles de mesure de 80 ms.

Dans ces conditions, pour effectuer une mesure correcte de l'impédance de fuite, il importe que t (durée de chaque étape de mesure d'un cycle) soit égale à $5_\tau$ comme indiqué plus haut.

Or, la capacité de fuite $C_f$ étant inconnue, il y a lieu de faire une calibration préalable à l'utilisation du dispositif de l'invention pour la surveillance en régime dynamique des défauts fugitifs.

Cette calibration va consister à créer une perturbation égale à 100 K $_\Omega$ en commutant en parallèle avec $Z_f$ une résistance égale à 100 K Ω en recherchant, par ajustage d'un potentiomètre (non représenté sur la figure 1) de fixation de la tension de référence REF, le niveau de référence qui permet d'obtenir le déclenchement du comparateur C pour une perturbation de 100 $K_\Omega$.

Suivant une autre caractéristique du procédé, il est préférable, du fait que l'injection d'un courant +I dans l'impédance de fuite $Z_f$ entraîne une modification de la tension de mode commun $V_{MC}$, d'éliminer ce phénomène par injection au point 3, durant l'étape 3, d'un courant de même valeur mais de signe opposé à celui du courant injecté durant l'étape 2, ce qui maintient la tension de mode commun à sa valeur initiale.

Le procédé peut également être utilisé pour la mesure en statique de l'isolement.

Les valeurs d'isolement atteignant couramment, en l'absence de défaut, un niveau égal ou supérieur à 20 M Ω, la durée d'un cycle de mesure du procédé devient alors importante.

En effet, si l'on tient compte du fait que t, durée de chaque étape de mesure du cycle, doit être égale à cinq fois τ pour obtenir $Z_f$ I et que la valeur maximale de $C_f$ est égale à 100 nF (valeur considérée comme une limite, mais qu'il faut envisager comme possible dans certains cas), on a :

$$\tau = 20.10^6 \times 100.10^{-9} = 2 \text{ secondes}$$

d'où t = 10 secondes

Ceci donne 40 secondes pour un cycle complet de mesure. Cette valeur de t est absolument nécessaire pour mesurer des impédances de 20 M Ω.

Ce genre de mesure est intéressant lorsque l'on désire connaître le niveau de l'impédance de fuite. Par contre, lors de séquences de tests du système actif, l'isolement peut présenter des perturbations et le procédé sera utilisé suivant le régime dynamique exposé plus haut afin de surveiller en permanence l'isolement et permettre de détecter des défauts fugitifs atteignant des valeurs aussi basses que 100 K $_\Omega$, par exemple, dans la mesure où leur durée est supérieure ou égale à celle d'un cycle de mesure, c'est à dire au moins égale à 80 ms, en fait 100 ms pour tenir compte de la durée de charge de la capacité de fuite.

Le procédé de l'invention s'applique, bien entendu, au contrôle de systèmes actifs alimentés aussi bien en courant continu qu'en courant alternatif.

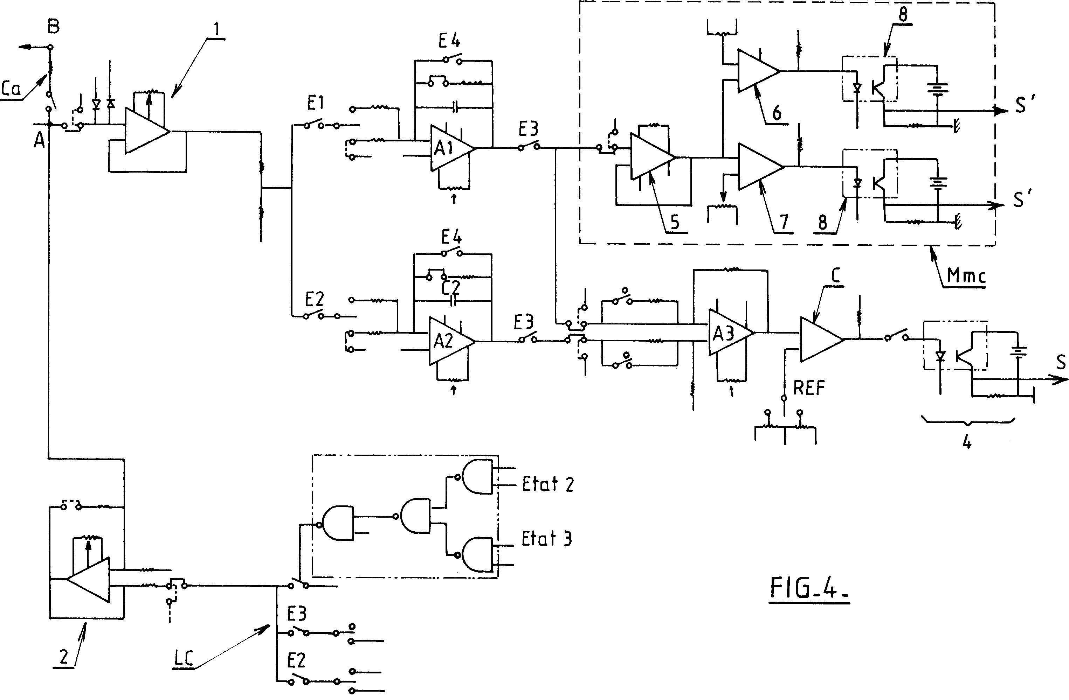

La figure 4 illustre un mode de réalisation d'un dispositif mettant en oeuvre le procédé de l'invention.

Les composants du circuit représenté homologues de ceux de la figure 1 portent les même références numériques.

On notera, en outre, sur la figure 4, le circuit Ca de calibration évoqué plus haut pour le fonctionnement en régime dynamique (détection de défauts fugitifs), le potentiomètre P d'ajustage du niveau de référence REF permettent d'obtenir le déclenchement du comparateur C pour une perturbation d'un seuil choisi, par exemple 100 K Ω , et la logique LC de commande de l'injection du courant ± I respectivement durant les étapes ou états 2 et 3 .

Les signaux de commande des contacts E1 à E4, conformément au chronogramme de la figure 2, sont générés par exemple par un dispositif de type connu représenté sur la figure 5, c'est à dire un circuit classique à bascules bistables B1, B2 et à quatre portes logiques PL, alimenté par le secteur 50 Hz et donc synchronisé avec lui.

Enfin, on a représenté en $M_{MC}$ sur la figure 4 un circuit optionnel permettant la mesure de la tension de mode commun $V_{MC}$, indépendamment de la recherche de défaut d'isolement.

Ce circuit comporte un amplificateur suiveur 5 susceptible d'être relié à l'intégrateur A1-C1 via un contact E3 et dont la sortie est connectée à deux comparateurs 6 et 7 de fixation de seuils de tension de référence, par exemple +60V et -60V, délivrant, via un étage de découplage 8, un signal de sanction S′ si le niveau de la tension de mode commun mesuré par l'intégrateur A1-C1 est supérieur ou inférieur à ± 60V, ce seuil pouvant bien entendu être ajusté.

De manière générale et en résumé, le procédé de l'invention s'applique à toute recherche de défaut d'isolement sur tout type de câblage en respectant parfaitement la notion d'impédance d'isolement.

Il s'applique à toute détection de défaut d'isolement sur des alimentations de tension de sous-ensembles électroniques.

Il permet de vérifier que les points d'alimentation restent flottants par rapport à des masses mécaniques et de suivre un isolement en dynamique.


## Revendications

1. Procédé de mesure et de contrôle de l'isolement électrique d'un système actif, caractérisé en ce qu'il consiste à effectuer, au cours d'une séquence de quatre échelons de temps successifs, d'une même durée égale à la période, ou un multiple de la période, du courant alternatif de fuite susceptible d'affecter le système :

   1/ une mesure de la tension de mode commun ($V_{MC}$) entre un point de référence électrique du système (A) et la masse environnante (M),

   2/ une injection d'un courant continu (I) d'amplitude déterminée, parallèlement à une mesure de la somme de la tension de mode commun et de la tension aux bornes de l'impédance de fuite ($Z_f$) générée par ledit courant injecté,

   3/ une mesure de la différence entre la somme des tensions mesurées à l'étape 2/ et la tension de mode commun mesurée à l'étape 1/, et

   4/ une remise à zéro des circuits de mesure (A1-C1 ; A2-C2) des étapes 1 et 2,

   en sorte d'obtenir par l'étape 3/, le courant injecté (I) étant connu, la valeur de l'impédance de fuite du système.

2. Procédé suivant la revendication 1, plus particulièrement destiné à la détection de défauts fugitifs d'isolement du système actif, caractérisé en ce que la durée du cycle de mesure constitué par les étapes 1/ à 4/ est de 80 ms, chaque étape ayant une durée de 20 ms correspondant à une période du réseau de distribution électrique 50 Hz, lesdites étapes étant synchronisées avec ce réseau.

3. Procédé suivant la revendication 1 ou 2, caractérisé en ce que la différence de tension obtenue à l'étape 3/ est comparée à une tension de référence (REF) correspondant à une impédance d'un seuil pré-déterminé choisi.

4. Procédé suivant la revendication 3, caractérisé en ce que la tension de référence (REF) est déterminée par calibration en créant une perturbation égale à une valeur d'isolement déterminée et en mesurant la valeur de la différence de tension (Vs) obtenue à l'étape 3/ et en affichant par la suite cette valeur comme référence (REF) de seuil de déclenchement d'un signal de défaut (S).

5. Procédé suivant l'une des revendications 1 à 4, caractérisé en ce que le cycle de mesure constitué par lesdites étapes 1/ à 4/ est répété automatiquement en sorte d'effectuer un contrôle permanent de l'apparition d'éventuels défauts fugitifs ou permanents.

6. Procédé suivant la revendication 1, plus particulièrement destiné à la mesure de l'isolement dudit système, caractérisé en ce que la durée du cycle de mesure constitué par les étapes 1/ à 4/ est de plusieurs dizaines de secondes, la durée de chaque étape du cycle de mesure étant fixée à cinq fois la constante de temps du circuit de fuite ($\tau$), en affectant une valeur déterminée considérée comme limite à la capacité de fuite ($C_f$).

7. Procédé suivant l'une des revendications 1 à 6, caractérisé en ce que durant l'étape 3/ on injecte audit point (A) du système un courant continu de même valeur que celui injecté durant l'étape 2, mais de signe contraire.

8. Dispositif pour la mise en oeuvre du procédé selon l'une des revendications 1 à 7, caractérisé en ce qu'il est constitué :
   - d'un générateur de courant continu (2) susceptible d'être connecté, par l'intermédiaire d'un contact (E2), à un point (A) de référence électrique du système,
   - d'un amplificateur suiveur (1) relié audit point (A),
   - d'un premier intégrateur (A1-C1) relié audit amplificateur suiveur (1) par un contact (E1),
   - d'un second intégrateur (A2-C2) relié audit amplificateur suiveur (1) par un contact (E2),
   - d'un amplificateur soustracteur (A3) relié respectivement auxdits premier et second intégrateurs (A1-C1 ; A2-C2) par l'intermédiaire de contacts (E3),
   - d'une source de référence (REF) de seuil d'isolement,
   - d'un comparateur (C) relié audit amplificateur soustracteur (A3) et à ladite source de référence (REF) et susceptible de délivrer un signal (S) indicatif de l'atteinte ou du dépassement par l'impédance de fuite mesurée (Vs) de ladite référence (REF),
   - et de moyens de commande séquentielle et cyclique desdits contacts (E1 à E4).

9. Dispositif suivant la revendication 8, destiné plus particulièrement à la mise en oeuvre de procédé selon la revendication 4, caractérisé en ce qu'il comporte, en outre, un circuit (Ca) de calibration résistif susceptible d'être branché en parallèle avec l'impédance de fuite ($Z_f$) du système.

10. Dispositif suivant la revendication 8 ou 9, caractérisé en ce que les moyens de commande séquentielle et cyclique desdits contacts (E1 à E4) sont constitués par un circuit générateur de signaux carrés (S1 à S4) formé de bascules bistables (B1, B2) et de portes logiques (PL) et alimenté par le secteur.

11. Dispositif suivant l'une des revendications 8 à 10, caractérisé en ce qu'il comporte, en outre, un circuit de mesure de la tension de mode commun ($M_{MC}$) susceptible d'être relié par un contact (E3) à la sortie du premier intégrateur (A1-C1) et de délivrer des signaux (S') indicatifs de l'atteinte ou du dépassement par ladite tension de mode commun ($V_{MC}$) d'un seuil, positif ou négatif, prédéterminé, réglable.

FIG.1.

FIG.5.

cycle de mesure

FIG.2.

FIG.3a.

FIG.3b.

FIG.3c.

FIG.3d.

FIG.4

Office européen
des brevets

# RAPPORT DE RECHERCHE EUROPEENNE

Numero de la demande

EP    92 45 0003

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D | EP-A-0 297 933  (MERLIN GERIN)<br>* Abrégé; colonne 1-2; figure 1 *<br>--- | 1,8 | G 01 R   31/02<br>G 01 R   27/18 |
| A | DE-A-2 357 081  (HARMS)<br>* Page 1, alinéa 1; page 2, alinéa 2 - page 3, alinéa 3; figures 1-3 *<br>--- | 1,8 | |
| D | FR-A-2 514 903  (CNRS)<br>* Page 2, ligne 19 - page 4, ligne 30; figures 1,5,6 *<br>--- | 1,8 | |
| A | FR-A-2 642 178  (MERLIN GERIN)<br>* Abrégé; figure 1 *<br>----- | 1,3,8 | |

**DOMAINES TECHNIQUES RECHERCHES (Int. Cl.5)**

G 01 R

Le présent rapport a été établi pour toutes les revendications

| Lieu de la recherche | Date d'achèvement de la recherche | Examinateur |
|---|---|---|
| LA HAYE | 06-07-1992 | IWANSSON K.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)